# EUROPEAN PATENT APPLICATION

(11) **EP 0 541 212 A2**
(43) Date of publication of application: **12.05.1993**
(21) Application number: 92307059.3
(22) Date of filing: 03.08.1992
(51) Int. Cl.: H01L 21/336, H01L 29/784

(54) **Process for fabricating semiconductor metal oxide device**

(30) Priority: 08.11.1991 US 790735
(71) Applicant: ADVANCED MICRO DEVICES, INC., Sunnyvale, CA 94088 (US)
(72) Inventor: Liu, Yow-Jang W., San Jose, CA 95120 (US); Shen, Lewis N. S., Cupertino, Califoria 95014 (US)
(74) Representative: Wright, Hugh Ronald

(57) **Abstract**

A method is provided for forming shallow lightly doped drain (LDD) (30) and source/drain junctions (34) without a spacer etch, which results in reduced junction resistance/capacitance and improved scalability. The method may also be extended easily to accommodate silicidation of source/drain regions for sub - micrometer integrated circuits. Essentially, a thin conformal film (28) is formed over the entire surface of a semiconductor substrate (10) after forming source/drain openings in the field oxide (12) and after forming the gate oxide (14) and metal gate (16) thereon. Implantation of the source and drain regions (32) simultaneously forms the LDD regions between the source/drain regions and the gate channel, due to the thickness of the thin film as it slopes from the top of the gate oxide/metal stack to the surface of the semiconductor substrate. The LDD junction is formed by one of three ways: (1) LDD implant before the thin conformal film deposition, (2) LDD implant after the thin conformal film deposition, and (3) diffusion from the phosphorus doped con - formal thin film. In this latter case, the P⁺ implant needs to be adjusted to compensate the phosphorus dopant in the P regions. In all three cases, the source/drain implant is always done after film depo - sition.

## Description

The present invention relates to the fabrication of semiconductor devices, such as the fabrication of junctions in sub - micrometer integrated circuits.

Semiconductor transistors are the building blocks for integrated circuits and the foundation of the modern micro-electronic age. In order to achieve better performance and larger storage capacities, the transistors have been made smaller and smaller, resulting in higher electrical fields across the transistors for a given operating voltage, which raises reliability concerns. Lightly - doped - drain (LDD) structures utilizing different spacer materials have been proposed to reduce the elec - trical fields and hot carrier injections (HCI) in the transistor to achieve better reliability.

Another important device reliability consideration during scaling is to minimize the short chan - nel effects, i.e., drain - induced barrier lowering, and maintain proper drain to source punch - through voltages for device operation. Shallow junctions are very desirable in order to avoid short channel effects for sub-micrometer devices. Shallow junctions are also needed for reducing junction capacitance and maintaining effective iso - lation during device scaling.

The conventional approach of forming LDD junctions includes a thin film deposition and a reactive-ion etch (RIE) to form LDD spacers along gate edges before source/drain implants. The pur - pose of the LDD spacer is to offset the high con - centration source/drain junctions from gate edges to reduce the hot carrier-induced device degradations. The lightly doped junction could either be introduced before or after the LDD spacer formation to bridge the gate channel and source/drain junctions.

The actual process of forming LDD spacers varies and is a function of spacer material. In some cases, when an oxide or nitride is used, a reactive-ion etch is needed and the oxide/nitride spacer removal is optional. In other cases, when polysilicon or a metal is used, a reactive-ion etch and a spacer removal step are required. The reactive - ion etch of oxide or nitride spacer would result in field oxide loss and worse step heights due to etch non - uniformity and loading effects.

Etch residues and low etch selectivity to un - derneath layers are common constraints in poly/metal spacer processes. These tight con - straints are potential causes for higher defect densities. This could result in significant device variations and yield losses. Spacer width control during the LDD spacer etch is another concern. For sub-micrometer circuits, the conventional LDD spacer process with loose width control can have a significant impact on the device reliability and performance.

The conventional methods of forming shallow (<0.2 _{I}.Lm) source/drain junctions include either low energy Si or Ge pre-amorphization implant followed by low energy source/drain implants and Rapid Thermal Process (RTP) to reduce drive - ins of the implanted species for junction formation. Neither of the above methods is defect-free. Very low energy implants are difficult to control the junction depths due to high sensitivity to implant pad oxide thickness variations. (The pad oxide protects silicon from implant damage and also prevents what is called the "implant channeling effect".) Pre-amorphization implant creates significant silicon damage and results in higher junc - tion leakages. Besides the poor temperature con - trol, RTP does not provide enough heat treatment to cure Si damage created by heavy source/drain implants. Self-aligned source/drain silicidation ("salicide") on shallow junctions for reducing junc - tion resistance is also known to have much higher junction leakages, especially at field and gate edges where junctions terminate. Using the con - ventional spacer process to form the insulator be - tween gate and source/drain during salicide formation often causes the shorting of gate to source/drain due to incomplete removal of silicide across spacers or spacer defects resulting from the spacer etch. One commonly used material for salicide is titanium silicide, which is very difficult to make good adhesion to poly gates. Large variations of salicided junction and gate integrity and sheet resistance have been reported. Another commonly reported problem of the conventional shallow junction process is the lower junction breakdowns.

The resultant device degradation and yield losses have limited the scalability of the conventional shallow junction process in high density and high performance sub-micrometer integrated circuit applications.

We will descibe a process for forming shallow lightly-doped-drain regions and source/drain junctions in metal - oxide semiconductor devices.

The present invention provides a process for fabricating a semiconductor metal - oxide semi- conductor device including:
(a) forming a gate oxide on a surface of a semiconductor substrate;
(b) forming a metal gate thereon;
(c) patterning the gate oxide and the metal gate to expose portions of the semconductor surface for forming source and drain regions therein;
(d) forming a thin film over at least the metal gate and the exposed portions;
(e) implanting a dopant through the thin film into the substrate to form the source and drain regions; and
(f) either prior to step (d) or subsequent there - to, introducing a dopant into the substrate adjacent the gate to form lightly doped drain regions.

The dopant may be introduced into the sub - strate by implantation through the thin film or by employing as the thin film a material which con - tains a species capable of diffusing at an elevated temperature, such as a phosphorus-containing glass.

The process to be described eliminates the need for a LDD spacer etch and results in reduced junction capacitance and silicon damage. Further, the novel method may be extended easily to accommodate silicidation of source/drain regions for sub - micrometer integrated circuits without risking gate to source/drain shorts.

Other objects, features, and advantages of the present invention will become apparent upon con - sideration of the following detailed description and accompanying drawings, in which like reference designations represent like features throughout the FIGURES.

### BRIEF DESCRIPTION OF THE DRAWINGS

The drawings referred to in this description should be understood as not being drawn to scale except if specifically noted. Moreover, the drawings are intended to illustrate only one portion of an integrated circuit fabricated in accordance with the present invention.
FIG. 1 is a cross - sectional view of a spacer as prepared by a typical prior art oxide spacer process;
FIG. 2 is a cross-sectional view, similar to a portion of FIG. 1, depicting the results of the process of the invention;
FIG. 3 is an enlargement of FIG. 2, depicting the implantation;
FIG. 4 is a top plan view of selective silicidation; and
FIG. 5 is a cross-sectional view, depicting an alternate embodiment of the invention.

Reference is now made in detail to a specific embodiment of the present invention

Alternative embodiments are also briefly described as applicable.

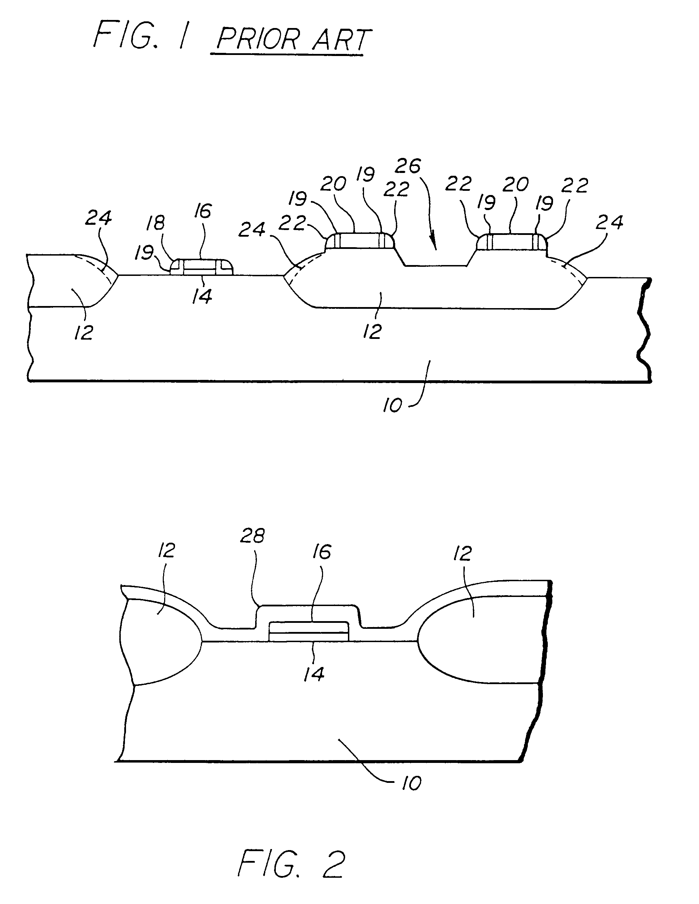

Referring now to FIG. 1, in which the results of a typical prior art oxide spacer process are illus - trated, a substrate 10 is shown, in which there has been formed a plurality of field oxide regions 12. A gate oxide 14, formed on a portion of the silicon substrate 10 in the active region between the field oxide regions, supports a metal gate 16. Spacers 18 are supported on and separated from the metal gate 16 by a pre - LDD implant oxide layer 19. The source/drain implants and oxidation are done after spacer formation. The field oxide 12 may support one or more interconnects 20 and associated spacers 22.

Due to LDD spacer etching, some of the field oxide 12 is lost, as indicated at 24. Further, goug - ing into the field oxide occurs, as indicated at 26. The gouging results in worse step heights, as dis - cussed earlier. This will result in a much less effective device isolation. Also, the oxide loss between interconnects positioned over the field region can cause poor topography and result in intercon - nect shorts.

In accordance with the improvement, the LDD spacers 18 are replaced by a conformal thin film 28 deposited over the gate metal 16. This depos - ited film serves the spacer function for LDD junc - tion formation without the need for a spacer etch, thereby avoiding loss of the field oxide 12 and gouging thereof.

With the conventional front end MOS process, the thin film 28, with thickness ranging from about 500 to 2,000 Å, is deposited after the gate is formed. This film can be either doped or undoped. TEOS (tetra - ethyl orthosilicate) is preferably em - ployed as the thin film 28, due to its conformality and good uniformity/thickness control. If the film 28 is doped with phosphorus, a counter dope during p + source/drain implant will effectively reduce p + junction depths. Significantly, no spacer etch is required.

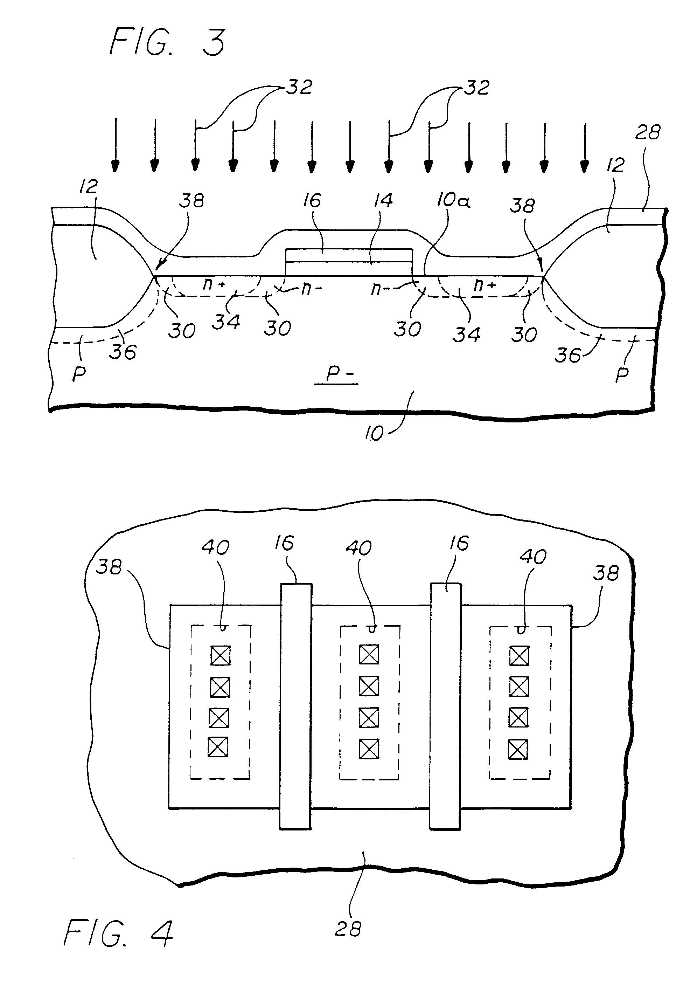

The source/drain implant, indicated by arrows 32, is directly implanted through this thin film 28 into the substrate 10 to form n + regions 34 to which source and drain contacts (not shown in FIG. 3) may be made. The thickness of the thin film 28 is chosen to meet the pre-determined spacer width requirements. The implant energy is chosen such that the implant peak is just below the silicon/thin film interface 10a, inside the silicon substrate 10. It is then followed by a short tem - perature anneal to form the junctions. Source/drain junctions are shallower near the gate and field edges due to spacer effects of the conformal TEOS film 28. This shallower junction, indicated at edge 38, reduces the amount of area where high con - centration source/drain junction and field implant species meet. Reduced junction capacitance, improved junction breakdown, and isolation enhance the circuit performance. The source/drain junction depth is deeper in the middle region which reduces the junction resistance. The resultant junction pro - files are preferred over conventional LDD and source/drain junction processes for device scaling. The total thermal budget can be reduced, since the TEOS film 28 is not etched away and no re- oxidation is needed prior to the source/drain im - plant. (It will be recalled that the conventional oxide spacer process requires etching and re-oxidation.) Also, a thinner source/drain oxide is needed in the process of the invention, as compared with the conventional poly spacer process.

The lightly doped implant may be done either before or after the deposition of the thin film 28 to form the LDD regions 30. If the LDD implant is done prior to TEOS 28 deposition, the gate edge will have shallow LDD junctions, but the source/drain junction profile at the field edges 38 will be controlled by the TEOS film. The advantage of this approach is that the effective channel length will be less dependent on the LDD process. An alternative way to form the LDD junction is to perform the LDD implant after the TEOS 28 depo - sition. The source/drain oxidation forms the source/drain junction and diffuses the LDD species to bridge the source/drain junction and channel regions simultaneously. The advantage of this ap - proach is that it can reduce the LDD junction overlap of the gate and improve the performance and short channel effects.

The desired implanted species for n - channel are arsenic for source/drain and phosphorus for LDD and for p - channel are boron sources such as B11 or BF₂ for source/drain and for LDD.

For the case of using oxide as the thin film 28, no film removal is needed after the source/drain implant. If polysilicon, silicon nitride, or metal is used as the thin film material, a thermal oxidation of the underneath layer and subsequent removal of the film 28 is needed. But, since the film 28 is uniformly covering the entire wafer, unlike leaving it partially exposed as in the conventional LDD etch process, a wet chemical etch with very high selectivity to the underneath oxide (not shown) can satisfactorily remove it. However, it should be noted that the selectivity requirement to the un - derneath oxide is not as stringent as the conven - tional LDD process, since there is no partially exposed underneath layer during the spacer removal. Therefore, a thinner underneath oxide may be used, and the reduction of thermal budget allows easier device scaling.

A deposited TEOS oxide is preferred over thermal oxide for the thin film 28. Using thermally grown oxide to form the spacer would add a con - siderable thermal budget to the process and would push up the gate edges, which would degrade the transistor performance and reliability.

Finally, in an alternative embodiment, implan - tation to form the LDD regions 30 may be replaced by employing as the film 28 a material which contains a species capable of diffusing at an elevated temperature. An example is phosphorus-containing silica glass (PSG). The use of this material in doping an underlying silicon substrate, and the parameters for carrying out such diffusion are well - known in the art.

The difference between the present arrange - ment and the conventional LDD etch process resides in the junction profile and the oxide thickness at the field edges. In the conventional process, there is a loss of oxide at the field edge (during the LDD etch), leading to a deeper junction and larger sidewall capacitance. The present invention provides a significant improvement.

The p - field junction regions 36 are formed by conventional field implant.

Since the film not only forms a thicker region along gate steps to allow the creation of LDD junctions 30, it also offsets the source/drain junc - tion edges 38 (as shown in FIG. 3), which could give lower junction capacitance and higher junction breakdown. This is particularly important in some applications such as high performance circuits and non -volatile memories, which require higher operating voltages. Besides providing lower junction capacitance and higher junction breakdown, the present invention also improves the effectiveness of isolation and allows further and more efficient device scaling.

Using oxide film as an example, this approach could easily accommodate salicidation by using an oversized contact mask plus selective openings to form salicide on critical speed paths.

Referring now to FIG. 4, inside the salicide mask openings 40, thin film (oxide) is etched away and salicide is formed. During the salicidation, the gate 16 and field edges 38 are protected by the thin film 28. Since there is no exposed field/junction edges and gates during silicide formation, the edge leakage problem and source/drain short to gate problem can thus be prevented. To reduce the resistance of gate polysilicon, a separate polycide 16a is used. The advantage of using thin film to form both LDD junctions 30 and shallow source/drain junctions 34 (with or without salicide) is that it forms preferred shallow junction profiles to meet device scaling and performance requirements with a much simplified process (no pre-amorphization needed) and less Si damage. A much simpler process and preferred junction profile are achieved by eliminating the reactive-ion spacer etch which could make device scaling much easier, since thinner field oxide could be used and better step height could be obtained.

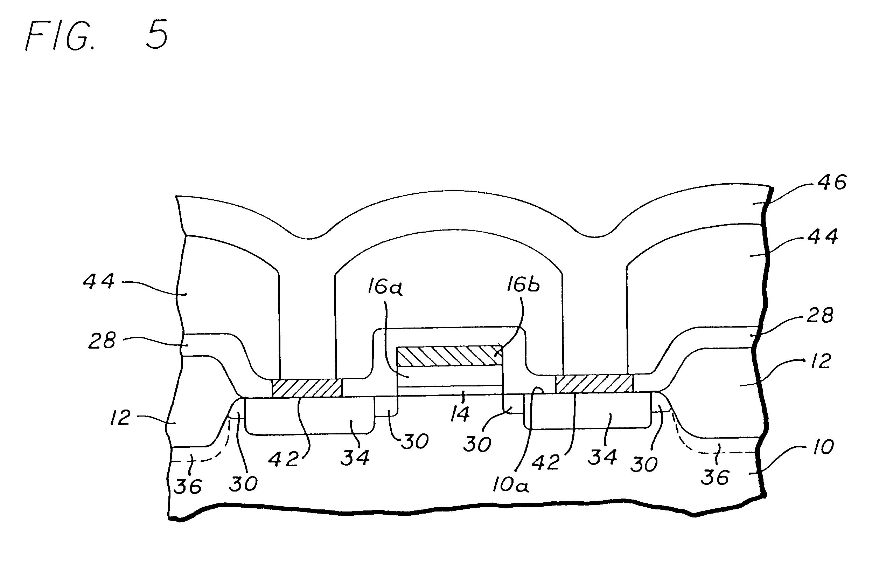

FIG. 5 depicts the structure resulting from the use of salicide. Here, a contact 42 to the source/drain regions 34 comprise a silicide, preferably titanium silicide. The gate 16 comprises a first layer 16a of polysilicon overlying the gate oxide 14 and a second layer 16b of a silicide, preferably tungsten silicide, contacting the poly - silicon layer. A thick oxide layer 44 is formed everywhere, and patterned to expose portions of the silicide contacts 42. The oxide layer 44 may comprise boron - phosphorus TEOS oxide or boron - phosphorus silicate glass. A metal layer 46, formed in the openings exposing the silicide con - tacts 42, makes contact to the silicide contacts.

The foregoing description of the preferred embodiment of the present invention has been presented for purposes of illustration and descrip - tion. It is not intended to be exhaustive or to limit the invention to the precise form disclosed. Obvi - ously, many modifications and variations will be apparent to practitioners skilled in this art. It is possible that the invention may be practiced in other fabrication technologies in MOS or bipolar processes. Similarly, any process steps described might be interchangeable with other steps in order to achieve the same result. The embodiment was chosen and described in order to best explain the principles of the invention and its practical application, thereby enabling others skilled in the art to understand the invention for various embodiments and with various modifications as are suited to the particular use contemplated. It is intended that the scope of the invention be defined by the claims appended hereto and their equivalents.

## Claims

1. A process for fabricating a semiconductor metal-oxide semiconductor device including:
(a) forming a gate oxide on a surface of a semi-conductor substrate;
(b) forming a metal gate thereon;
(c) patterning said gate oxide and said metal gate to expose portions of said semiconductor for forming source and drain regions therein;
(d) forming a thin film over at least said metal gate and said exposed portions;
(e) implanting a dopant through said thin film into said substrate to form said source and drain regions; and
(f) either prior to step (d) or subsequent thereto, introducing a dopant into said sub - strate adjacent said gate to form lightly doped drain regions.

2. The process of Claim 1 wherein said thin film ranges in thickness from about 500 to 2,000 A and is chosen to meet predetermined spacer width requirements.

3. The process of Claim 2 wherein said dopant is introduced into said substrate to form said lightly doped regions by implantation.

4. The process of Claim 3 wherein said dopant implanting is carried out at an energy such that the implant peak is just below the interface formed between said silicon surface and said thin film, inside said substrate.

5. The process of Claim 1 wherein said thin film consists essentially of an oxide.

6. The process of Claim 5 wherein said thin film includes a species capable of diffusion.

7. The process of Claim 6 wherein said thin film consists essentially of a phosphorus-containing glass and wherein said species capable of diffusion consists essentially of phosphorus.

8. The process of Claim 7 wherein said dopant is introduced into said substrate to form said lightly doped regions by diffusion of phosphorus at an elevated temperature subsequent to step (d).

9. The process of Claim 1 wherein said thin film consists essentially of a material selected from the group consisting of polysilicon, silicon nitride, and metal and wherein a thermal oxi - dation step is performed prior to depositing said thin film and wherein said thin film is removed following implantation of said source and drain.

10. The process of Claim 1 further including forming openings in said thin film to expose portions of said source and drain regions in said semiconductor substrate and forming metal silicide contacts thereto.

11. The process of Claim 10 wherein said metal silicide consist essentially of titanium silicide.

12. The process of Claim 1 wherein said metal gate comprises a first layer of polysilicon and a second layer of a metal silicide.

13. The process of Claim 12 wherein said metal silicide consists essentially of tungsten silicide.
